# EUROPEAN PATENT APPLICATION

(11) **EP 1 804 305 A1**
(43) Date of publication of application: **04.07.2007**
(21) Application number: 07007810.0
(22) Date of filing: 27.05.1999
(51) Int. Cl.: H01L 33/00, H01S 5/323

(54) **A method of producing a gallium nitride-type light emitting semiconductor device**

(30) Priority: 28.05.1998 JP 14704998
(62) Divisional of application: 99110299.7
(71) Applicant: Sumitomo Electric Industries, Ltd., Chuo-ku Osaka 541 0041 (JP)
(72) Inventor: Motoki, Kensaku, Itami-shi Hyogo (JP)
(74) Representative: Grünecker, Kinkeldey, Stockmair & Schwanhäusser Anwaltssozietät

(57) **Abstract**

A method of producing a gallium nitride-type light emitting semiconductor device comprising the steps of growing GaN-type semiconductor epitaxial layers on a (0001) top surface gallium nitride single crystal substrate; forming an electrode on the GaN-type semiconductor epitaxial layers; forming an electrode on a bottom surface of the gallium nitride single crystal substrate; forming scribing lines on the bottom surface of the gallium nitride single crystal substrate along {1-100} planes of the gallium nitride single crystal substrate; cutting the gallium nitride single crystal substrate into chips by cleaving along the scribed lines and obtaining light emitting device chips having sides consisting of {1-100} planes made by natural cleavage.

## Description

This invention relates to light emitting devices, e.g. light emitting diodes (LEDs), semiconductor lasers (LDs) and so on that utilize gallium nitride (GaN) single crystal substrates. GaN-type devices have already been put into practice as blue light emitting devices. It is impossible to obtain a large-scaled GaN substrate, so that nowadays, gallium nitride (GaN) is heteroepitaxially grown on a pertinent foreign material as a substrate other than GaN. Here, the "GaN-type" includes mixed crystals, for example, InGaN, AlGaN and so on, because they are also epitaxially grown in the case of producing light emitting devices.

Conventionally, almost all the light emitting devices using nitride-type semiconductors use sapphire as substrates. The sapphire substrate is used for producing LDs ( Laser Diodes), LEDs (Light Emitting Devices) and so on by growing GaN-type films thereon. Sapphire is a suitable material for the substrate of the epitaxial growth at a high temperature due to its properties, e.g. high stability, high rigidity, high heat-resistance, high chemical resistance and so on. The growth of a GaN single crystal has been brought into practice through the developments of an AlN buffer technique and a low-temperature GaN buffer technique, in spite of about 16% of lattice mismatching between the GaN single crystal and the sapphire substrate. Since thin GaN-type crystal layers are grown alone on a sapphire substrate, the GaN layers accompanied by the sapphire substrate are directly processed to make a light emitting device. The basic part of a GaN-type LED or a GaN-type LD is made of sapphire. To be brief, only extremely thin GaN layers, which are a light emitting part, are deposited on a sapphire substrate. As a result, such a complex device consisting of sapphire and GaN, i.e. GaN/sapphire, has two serious drawbacks.

One is a great number of crystal defects. The 16% lattice mismatching between GaN and sapphire obliges the GaN film to heighten the density of defects, because the GaN film is heteroepitaxially grown on the sapphire. The GaN light emitting diodes and GaN laser diodes put on sale have high densities of dislocations, for example, about 109cm-2, but they can emit strong blue light. The lifetime of GaN-type LED is supposed to be about 10, 000 hours in spite of many defects included in the GaN-type films. This fact goes against the common sense in the conventional semiconductors, but is true. The high density of defects is, however, supposed to depress the lifetime in the case of GaN LDs because of high current densities. Therefore, a GaN-type laser diode having a lower density of defects is supposed to enjoy a higher efficiency and a longer lifetime.

The other drawback of the sapphire substrate is derived from "non-cleavage", that is, the lack of cleavage planes. Since an Si substrate or a GaAs substrate has natural cleavage planes in the directions perpendicular to each other, a wafer is easily diced up into individual chips along two groups of parallel lines being at right angles to each other and to the wafer surface. The cleavage plane is an even and mirror surface. Hence, the dicing is easily done because of the natural cleavage planes.

In contrast to Si or GaAs, since sapphire has no cleavage planes, the sapphire is forced into cutting with a mechanical cutter, for example, a rolling blade for dicing up a processed sapphire wafer into individual LED chips. It takes much time to dice the sapphire wafer into individual chips line by line because of the rigidity and the non-cleavage of sapphire. Further, cut surfaces are not a smooth mirror plane. This fault is called "the difficulty of cutting".

Besides the difficulty of cutting, there exists another difficulty of producing a resonator in the case of LDs. As mentioned above, since the GaN film deposited on sapphire has non-cleavage, a cut surface forcedly diced by a mechanical means would not be an even mirror surface and would have a low reflection factor, even if the cut surface were polished, unlike the natural cleavage plane. The natural cleavage planes should be assigned to resonator surfaces.

This invention is conceived for solving the problems that the sapphire substrate has non-cleavage and the GaN film grown on the sapphire substrate has a high density of dislocations. There is no way to overcome these difficulties as long as sapphire is used as a substrate material. The use of sapphire should be abandoned.

Another idea is proposed in which SiC is used as a substrate material instead of sapphire. SiC is endowed with cleavage, rigidity and heat-resistance, but SiC is too expensive to supply. If SiC were used as a substrate material, still a higher cost would be required. Although SiC is made tentatively and experimentally for using as a substrate material, the mass-production of SiC substrates is not practical yet.

Even if a foreign substrate material, which differs from GaN, has cleavage, such cleavage is only for substrate crystals. Not all foreign substrate crystals coincide with the GaN thereon in cleavage. The dicing would become easier due to the cleavage of substrate materials, but there is no qualification for working as a resonator of the LD.

GaN single crystal endowed with cleavage is the most suitable for a substrate of a GaN light emitting device. When a GaN film is homoepitaxially grown on a GaN substrate, the density of dislocations must be much less than in GaN layers grown on other crystals. Hence, the GaN laser diode deposited on the GaN substrate ought to have a longer lifetime than the lasers on other substrate crystals.

GaN substrate is ideal for growing a GaN layer, but a large-scaled bulk GaN crystal capable of using as a substrate could never be produced. Bridgman method and Czochralski method are appropriate methods for producing large-scaled crystals. The first steps of these methods start from a material melt. A large sized single crystal is produced by dipping a seed crystal into the material melt and expanding a solid part gradually. However, GaN never becomes a melt by heating. Therefore, the crystal growth methods for obtaining a solid phase from a liquid phase can not be used for GaN. Ga-GaN solution can be produced by dissolving a small amount of GaN into a Ga solvent, but a large-scale equipment, i.e. ultrahigh pressure vessel, is necessary for obtaining tens of thousands of atmosphere pressure. The space satisfying ultrahigh pressure condition is too narrow to make a large-scale, bulk crystal. As a result, it is impossible to make a GaN crystal large enough to employ as a substrate by the commonplace crystal growth methods, i.e. Bridgman method and Czochralski method, because these methods are for obtaining solid phases from liquid phases. Another method, for example, sublimation method seems to be available, because GaN solid is heated to be gas directly, but the sublimation method can not produce a large-scale single crystal enjoying a regular orientation and a regular shape. After all, every ordinary single crystal growth method is unfit for GaN.

Inventors of this invention thought of an innovative idea that the layer growth methods can be diverted to the production of substrate crystal. A large-scale GaN thin layer is heteroepitaxially grown on a GaAs substrate by the vapor phase growth method. The thickness of the GaN layer is increased step by step, and the GaN layer with a sufficient thickness is obtained in the end. In the concrete, the GaAs substrate is coated with a special mask having windows and each GaN layer is individually deposited within each aperture part (window) formed on the mask. GaN layers are unified above the mask to make a freestanding GaN bulk single crystal. Independent individual GaN nuclei generated within the windows bring about the growth of a large-scale GaN single crystal. It is called " lateral growth". Various shapes are available for mask windows, for example, dotted windows, striped windows and so on. Here, we will explain about the GaN lateral growth method in detail in which a mask having dotted windows is adopted.

This method has been disclosed in Japanese Patent Application No.H9-298300 (No.298300/1997) and Japanese Patent Application No.H10-9008 (No.9008/1998) which were filed by the applicant of this invention. Firstly, the lateral growth of GaN will be explained, which will be written in the item of Embodiments of the present invention. GaAs (111) A surface is used as a substrate, which has three-fold symmetry. The GaAs (111) A surface is a plane occupied only by Ga atoms lining up. The GaAs (111) B surface is a plane occupied only by As atoms lining up. The substrate is coated with a mask made from SiO₂ and so on that are materials for inhibiting the growth of GaN. Groups of windows lining up in the direction of [11-2] are provided with the mask. Each window is formed on the vertexes of an equilateral triangle having one side in [11-2] direction.

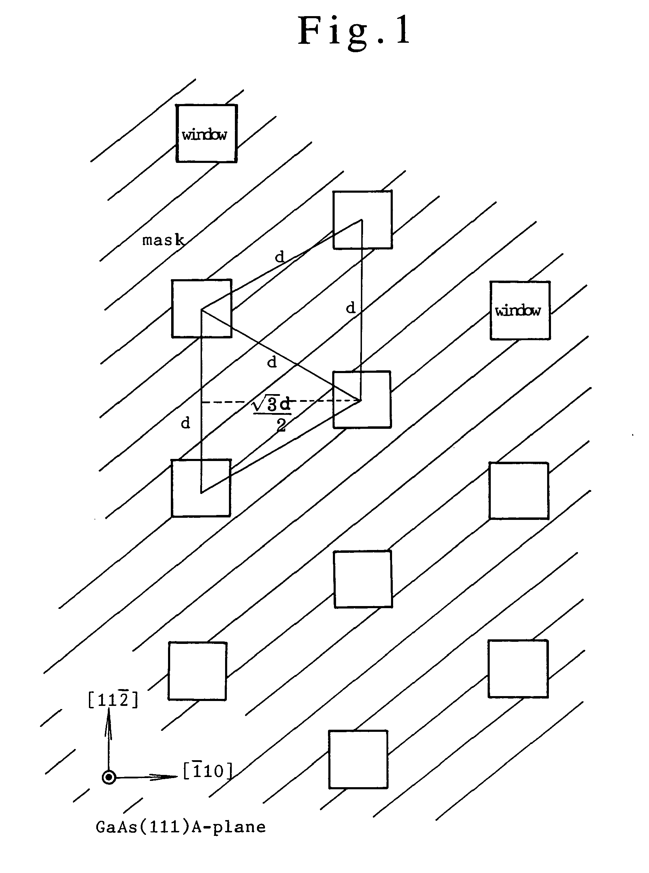

Fig.1 shows an arrangement plan of the mask and the windows. Series of windows are arranged by a regular pitch of "d" in [11-2] direction. The distance in [-110] direction between neighboring series is expressed by 3^{1/2} d/2. One window has six nearest neighbor windows, and every distance between neighboring windows is "d". The size and the shape of window are arbitrary. The arrangement is very important. No GaN nucleus occurs on the mask but GaN nuclei occur only in the GaAs revealed foundation, wherein the GaN nuclei conform to the GaAs crystal in orientation. Hence, the GaN surface becomes a (0001) plane having six rotation symmetry.

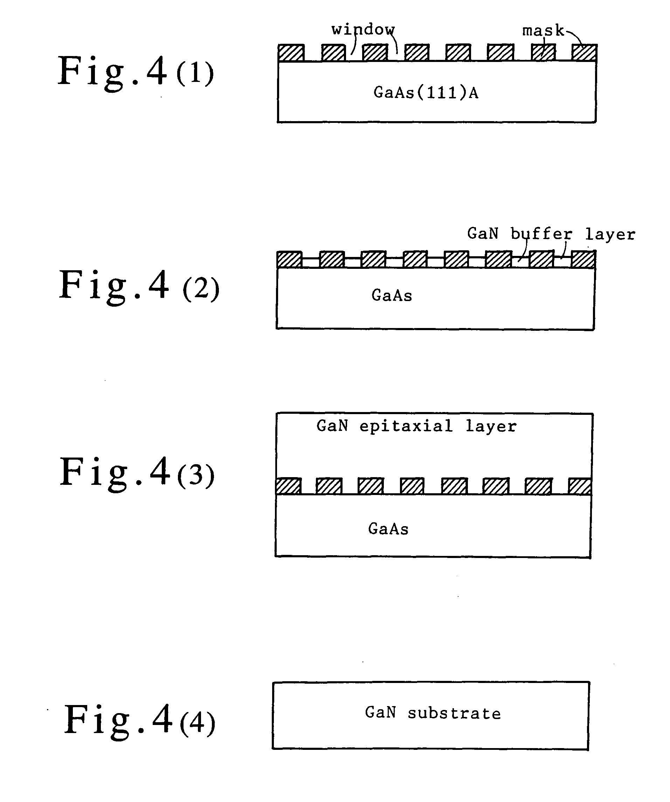

Fig.4(1) is a partial sectional view of the arrangement plan of the windows and the mask shown in Fig.1. Here, rules with respect to the orientation will be written. In crystallography, symbols for expressing plane orientations collectively are assigned by enclosing plane indexes with middle brackets, i.e. {kmn}. The collective expression contains all planes capable of changing to individual planes (klm) by all symmetry operations (O) included in the crystal system. Individual plane orientations are expressed by enclosing plane indexes with small brackets, i.e. (klm).

The directions perpendicular to these individual plane orientations are expressed with the same plane indexes. The individual directions are expressed by enclosing plane indexes with large brackets, i.e. [klm]. The collective orientation is denoted by enclosing plane indexes with quotation marks, i.e. 〈klm〉 . The collective expression 〈klm〉 is an assembly of all individual directions capable of changing to individual directions [klm] by all symmetry operations (O). These expressions are basic rules, but are sometimes misused.

The plane indexes klm are positive or negative integers. When the plane indexes are negative integers, horizontal lines are put above numbers, which is used in the figures of this invention, but in the specification, minus marks are put in the front of numbers. Since commas are not put between numbers, it is uneasy to understand directly, but such an expression is unavoidable. -2 of [11-2] means 2 in negative direction, so that a minus mark should be put above the number 2.

GaAs is a cubic symmetry crystal. Three axes a, b and c are of equal length and are perpendicular to each other. A set of planes is simply denoted by three plane indexes (klm). The first plane of the set of parallel planes goes across three axes a, b and c at the points of a/k, b/l and c/m.

GaN is a hexagonal symmetry system. Four axes a, b, d and c are used. Three axes a, b and d are main axes being at an angle of 120 degrees with each other on a plane, and are not independent each other. C-axis is perpendicular to these three axes a, b and d. GaN crystal has a six-fold symmetry around c-axis. There are two sorts of expression, one is four-index expression and the other is three-index expression for hexagonal symmetry crystal. Here, the four-index expression is used. The plane (klnm) means that the first plane of the set goes across the axes a, b, d and c at the points of a/k, b/l, d/n and c/m. c axis is independent but the axes a, b and d are not independent. There exists the zero-sum rule, i.e. k+1+n=0, among three indexes of a, b and d. The plane (0001) is a surface (c-plane) having a six fold symmetry around a normal line (c-axis).

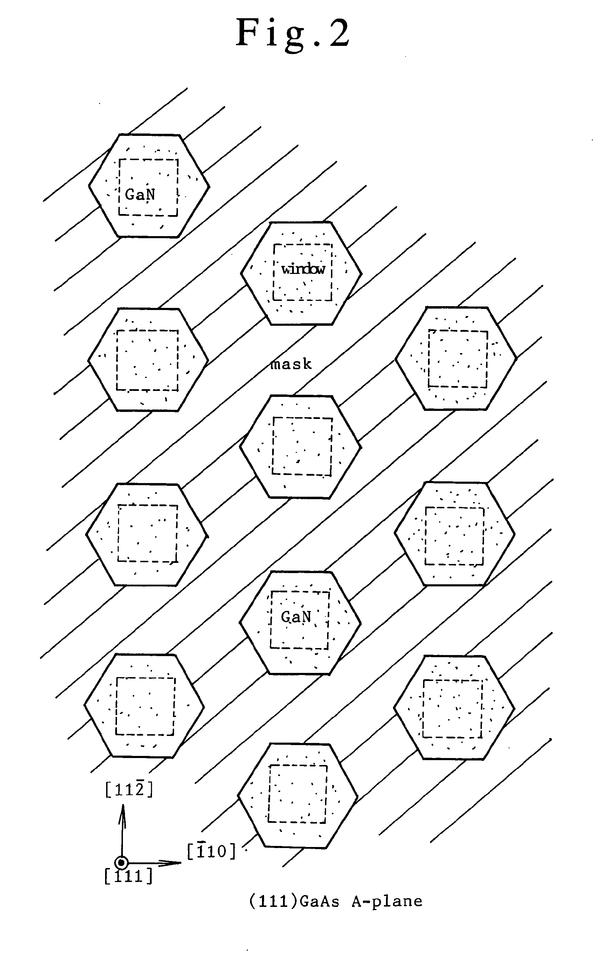

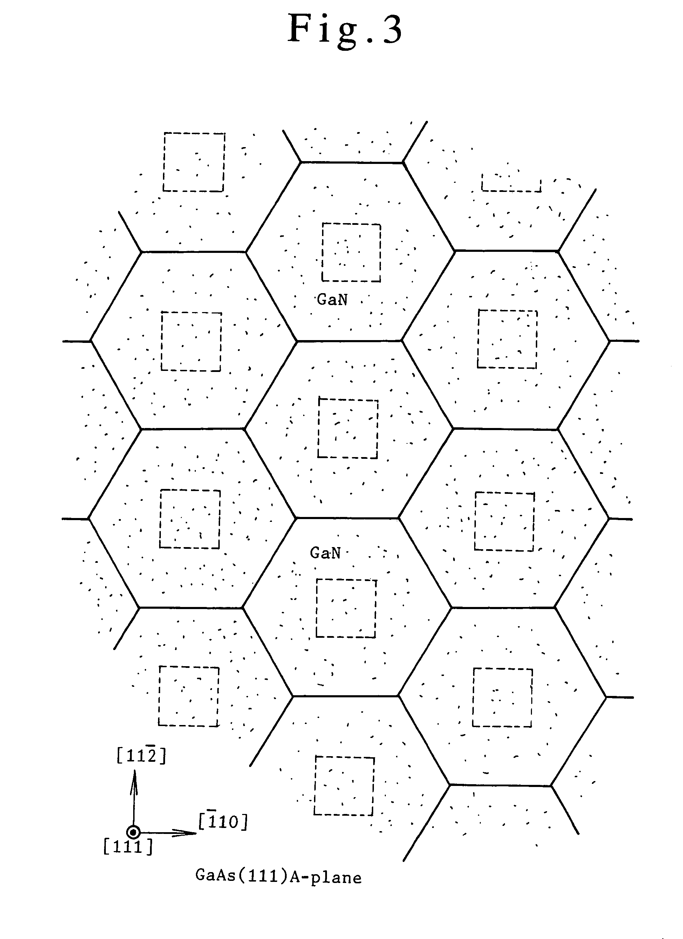

A GaN buffer layer is grown on the GaAs substrate coated with the mask, which is shown by Fig.1 and Fig.4(2), at a relatively low temperature by vapor phase growing methods, for example, MOC (MetallOrganic Chloride) method, HVPE (Halide Vapor Phase Epitaxy) method, MOCVD (MetallOrganic Chemical Vapor Deposition) method and so on. The growth of GaN buffer layer is illustrated in Fig.4(2). The GaN layer is further grown beyond the thickness of the mask at high temperature. As shown by Fig.4(3), the thickness of the GaN layer becomes much thicker than that of the mask. In this case, the sublimation method is also allowable as well as MOC, HVPE, MOCVD and so on. The GaN crystal spreads also on the mask as soon as the GaN layer exceeds the mask in thickness, which is shown by Fig.2. Each GaN crystal expands in the shape of a regular hexagon from each window (aperture). When the GaN buffer layers continue to grow beyond the mask, the GaN layers are brought to contact with the neighboring GaN layers growing from neighboring windows, which is shown by Fig.3.

When the GaN layer is further grown, a thick GaN crystal is produced, as shown by Fig.4(3). In the next stage, the GaAs substrate is removed by etching. The mask is also removed by polishing. A thick, isolated GaN layer can be produced by the epitaxial growth methods. This crystal is utilized as a substrate crystal due to the independency (freestanding state).

The methods of producing a GaN crystal will be described hereafter. These methods are vapor phase epitaxies but have differences in starting materials and intermediate products.

### 1. HVPE (Halide Vapor Phase Epitaxy) method

Molten gallium (Ga) reacts with HCl to generate GaCl, and GaCl reacts with ammonia (NH₃) to synthesize GaN, that is,

Ga + HCl → GaCl, GaCl + NH₃ → GaN

Metal gallium (Ga) is used as a Ga material. This method is characterized in that GaCl has been once synthesized, which is the reason why the word "Halide" is annexed thereto.

### 2. MOC (Metallorganic Chloride) method

Metallorganic gallium, e.g. trimethyl gallium Ga(CH₃ )₃, reacts with HCl to generate GaCl, and GaCl reacts with ammonia (NH₃) to synthesize GaN, that is,

Ga(CH₃)₃ + HCl → GaCl, GaCl + NH₃ → GaN

### 3. MOCVD (Metallorganic Chemical Vapor Phase Deposition) method

Metallorganic gallium, e.g. trimethyl gallium Ga(CH₃)₃, reacts with ammonia (NH₃) directly to synthesize GaN, that is,

Ga(CH₃)₃ + NH₃ → GaN

The difference between MOC method and MOCVD method should be noticed. MOCVD is a popular method for growing GaN on sapphire.

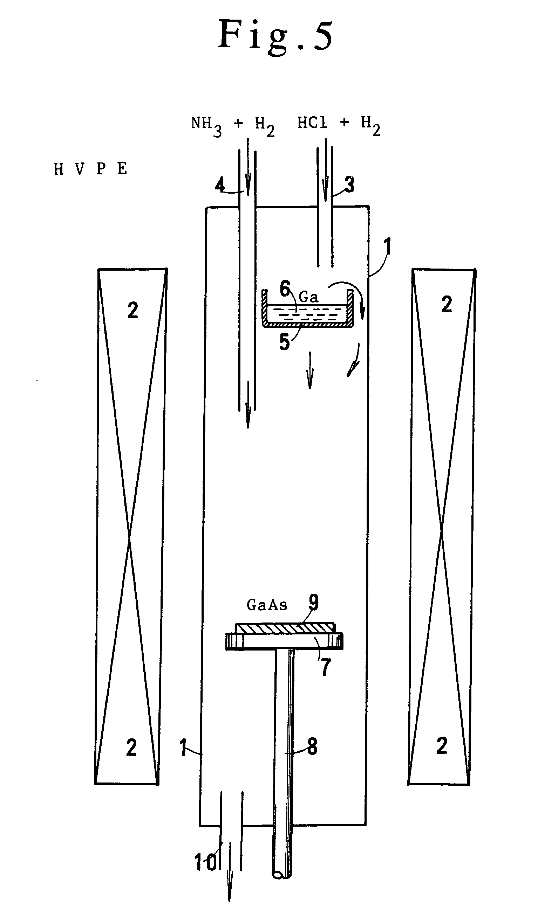

Fig.5 shows a schematic view of an HVPE apparatus. A cylindrical heater 2 is equipped around a vertical reactor 1. The heater is actually divided into several parts in the vertical direction in order to form the distribution of temperature. Material gas leading tubes 3 and 4 are inserted into the top of the reactor 1. (NH₃ + H₂) gas is introduced from the material gas leading tube 3, and (HCl + H₂) gas is introduced from the material gas leading tube 4. There is a Ga vessel filled with metal Ga at an upper position of the reactor 1. Ga melt 6 is produced by heating the metal gallium (Ga). A susceptor 7 and a shaft 8 are provided with the bottom of the reactor 1, and they can rotate and move up and down. A GaAs substrate 9 is positioned on the susceptor 7. The reactor 1 has a gas exhaust hole 10 connecting to a vacuum exhaust device ( that is not shown) on the bottom side. HCl reacts with Ga liquid to generate GaCl. The generated GaCl flows downward and reacts with NH₃ . GaN grows on a GaAs wafer 9 as a layer.

To achieve the foregoing objects and in accordance with the purpose of the invention, embodiments will be broadly described herein.

A purpose of the present invention is to provide a GaN-type light emitting device having cleavaged sides. Another purpose of the present invention is to provide a GaN-type light emitting device in various shapes having the sides all cleavaged.

This invention produces a GaN light emitting device by using GaN as a substrate in order to get cleavage planes, and dices up the GaN light emitting device into a plurality of light emitting device chips along the cleavage planes. To be more concrete, this invention includes the steps of depositing the GaN-type thin layer on the GaN (0001) substrate by the epitaxial growth methods, forming an n-side electrode to the bottom of the GaN (0001) substrate, forming a p-side electrode to the top of the GaN-type layer, producing a plurality of light emitting device structures in both vertical and horizontal directions, and cutting the light emitting device structures into chips along the cleavage planes. The circumferences of chips should be cut along cleavage planes. The dicing process is simplified, because the chip division fully or partially utilizes the natural cleavage. The whole circumferences are cut along cleavage planes in the case of LEDs. Hence, the LED of this invention has cleavage planes in all side surfaces. In the LD of this invention, resonator surfaces are defined to be cleavage planes, and other surfaces except for the resonator surface are not necessary to be cleavage planes.

The cleavage plane of GaN is expressed with {1-100}, which is also expressed with individual planes, that is, (1-100), (01-10), (-1010), (-1100), (0-110) and (10-10). The GaN substrate has a (0001) surface. Each individual plane is at an angle of 60 degrees with each other, and further is perpendicular to the substrate surface. When the GaN crystal is cut along the cleavage planes, the circumference sides of the GaN crystal are at right angles with the substrate surface. Since the circumferences are a cleavage planes in the LED of this invention, the inner angles of the corers are either 60 degrees or 120 degrees. The inner angle of 90 degrees does not exist in the LEDs.

It is possible to provide a variety of LED chips in shape that are diced along cleavage planes, for example, an equilateral triangle LED chip (shown by Fig.7), a lozenge LED chip (shown by Fig.8), a parallel quadrilateral chip (shown by Fig.9), a trapezoid chip (shown by Fig.10), a regular hexagon chip (shown by Fig.11) and so on.

In the LD of this invention, resonator surfaces are at least formed by the cleavage. If other sides require cleavage planes, a parallel quadrilateral or a trapezoid is available. If other sides require no cleavage planes, rectangle chips are allowable. When the resonator surfaces are cleavage planes, they are even and have a high reflective factor.

This invention makes light emitting devices, e.g. LED, LD and so on by epitaxially growing GaN-type layers on the (0001)GaN single crystal substrate wafer, and cutting the processed GaN wafer along the cleavage planes {1-100} into chips. The natural cleavage is a great help to an easy dicing of the wafer to chips. This invention can gift a low cost of production to the GaN-type light emitting devices. LEDs having different shapes are desirable for anisotropic light sources. In the case of LDs, the cleavage plane becomes a mirror surface. This invention is effective in enhancing the properties and the yield of GaN-type LEDs and LDs.

Examples of the invention will be described with reference to the several figures of the accompanying drawings in which:
Fig.1 is a partial plan of a mask having square windows at vertexes of equilateral triangles wherein one sides of the equilateral triangles are in parallel to the direction of [11-2] of GaAs by coating a mask on a GaAs(111) A surface substrate and forming the windows on the mask by lithography.
Fig.2. is a partial plan view showing the state of the growing GaN films which is piling on a GaAs surfaces exposed in the windows and expanding beyond the windows in horizontal directions as shaping a regular (equilateral) hexagon.
Fig.3 is a partial plan view showing the state of regular hexagon GaN crystals being in contact with each other and covering masks.
Fig.4(1) is a sectional view of the state in which a mask formed on a GaAs(111) A surface, and windows are perforated in the mask.
Fig.4(2) is a sectional view of the state in which GaN buffer layers are formed within the windows on the GaAs surface.
Fig.4(3) is a sectional view of the state in which the GaN epitaxial layer is further grown on the GaN buffers above the top of the mask.
Fig.4(4) is a sectional view of the state in which the GaN layer substrate is obtained as an independent freestanding layer by removing the GaAs substrate.
Fig.5 is a schematic sectional view of the apparatus for growing a GaN crystal on a GaAs substrate by an HVPE method.

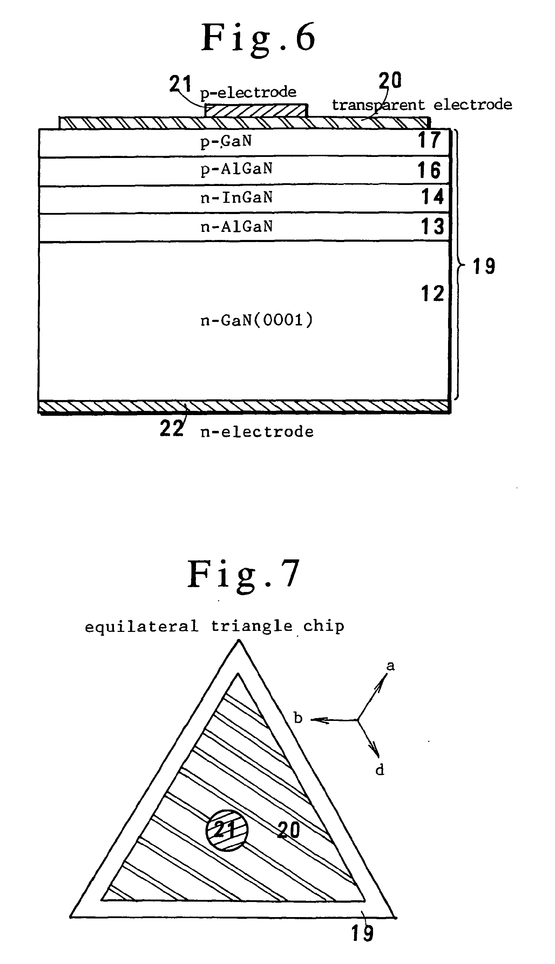

Fig.6 is an example of an epitaxial structure of a GaN light emitting device produced on a GaN substrate.
Fig.7 is a plan view of a triangle-type LED chip with respect to an embodiment of the present invention in which the cleavage planes are assigned to three circumferences.

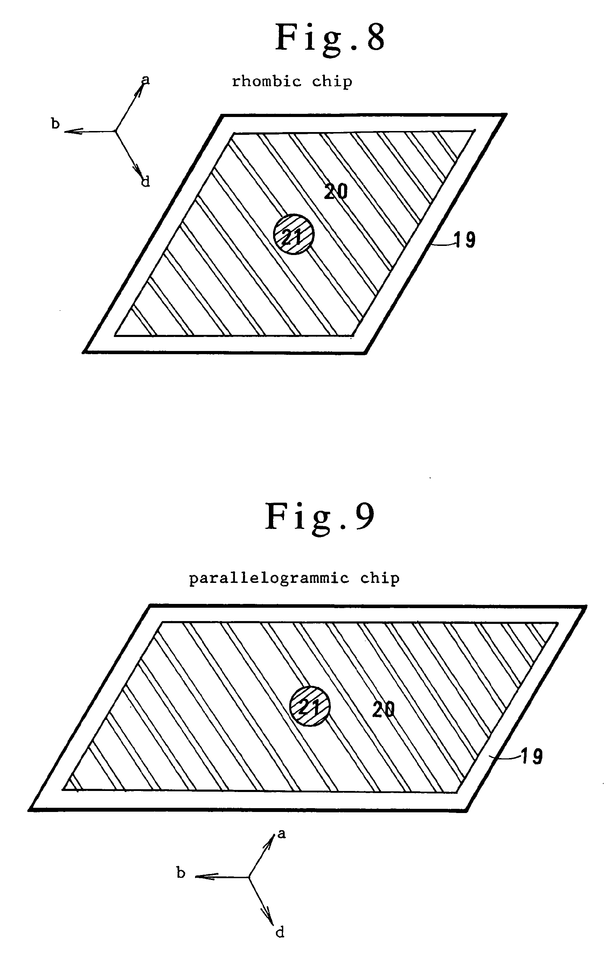

Fig.8 is a plan view of a lozenge(rhombic)-type LED chip with respect to an embodiment of the present invention in which the cleavage planes are assigned to four circumferences.
Fig.9 is a plan view of a quadrilateral(parallelogrammic)-type LED chip with respect to an embodiment of the present invention in which the cleavage planes are assigned to four circumferences.

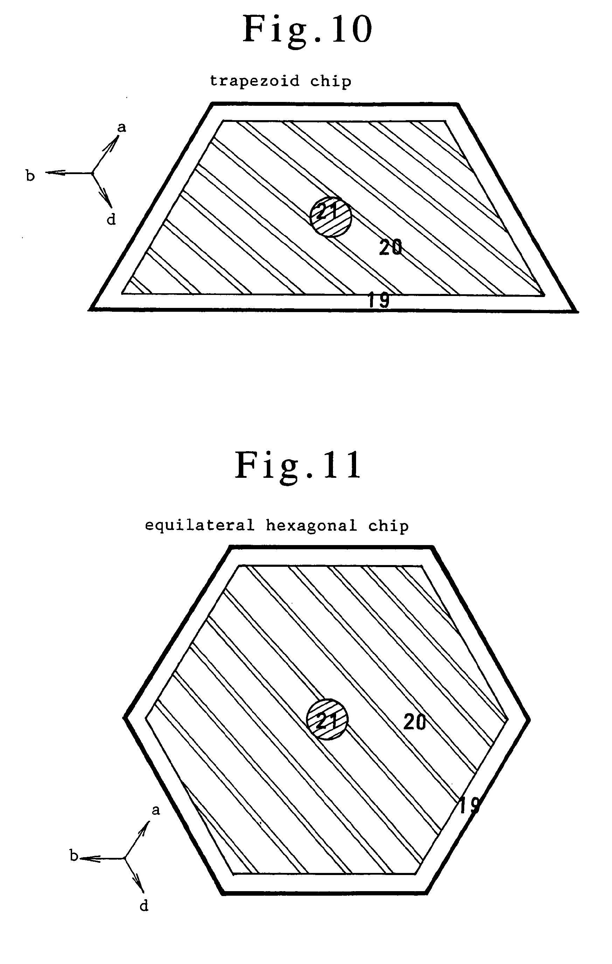

Fig.10 is a plan view of a trapezoid-type LED chip with respect to an embodiment of the present invention in which the cleavage planes are assigned to four circumferences.

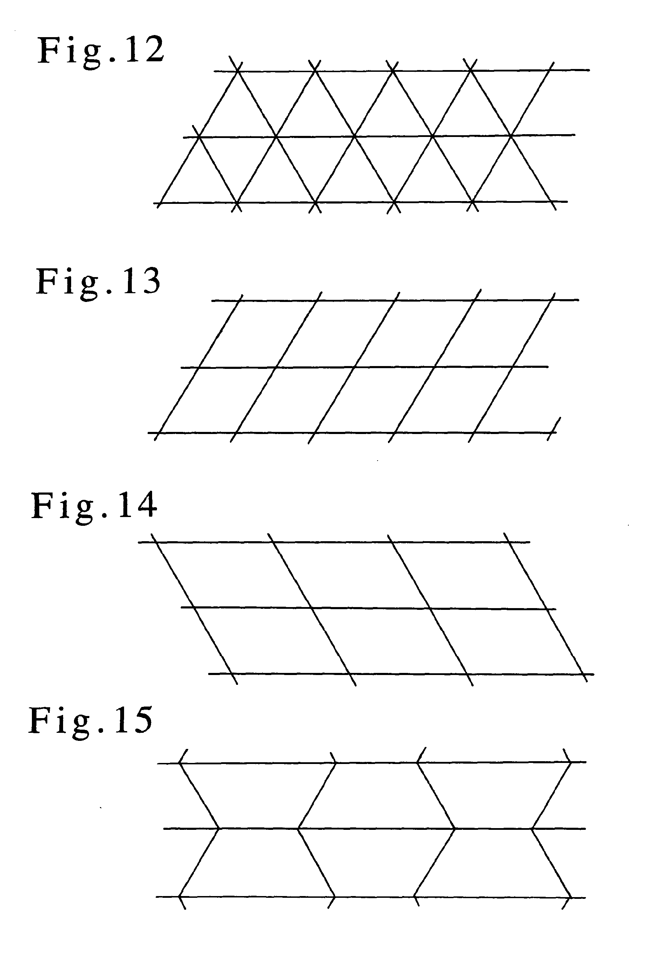

Fig.11 is a plan view of a regular(equilateral) hexagon-type LED chip with respect to an embodiment of the present invention in which the cleavage planes are assigned to six circumferences.
Fig.12 is a partial plan view for showing a group of cutting lines scribed along cleavage planes on the GaN wafer in order to obtain triangle-shaped chips.
Fig. 13 is a partial plan view for showing a group of cutting lines scribed along cleavage planes on the GaN wafer in order to obtain lozenge(rhombic)-shaped chips.
Fig. 14 is a partial plan view for showing a group of cutting lines scribed along cleavage planes on the GaN wafer in order to obtain quadrilateral(parallelogrammic)-shaped chips.
Fig.15 is a partial plan view for showing a group of cutting lines scribed along cleavage planes on the GaN wafer in order to obtain trapezoid-shaped chips.

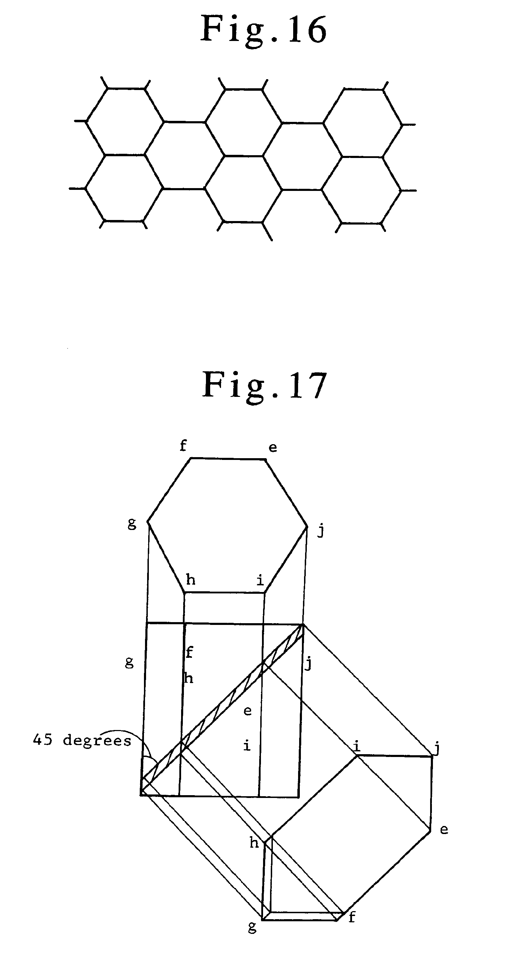

Fig.16 is a partial plan view for showing a group of cutting lines scribed along cleavage planes on the GaN wafer in order to obtain regular triangle-shaped chips.
Fig.17 is a line figure for explaining that the neighboring cleavage planes meet at right angles by inclining a (0001) chip surface at an angle of 45 degrees to a certain direction.

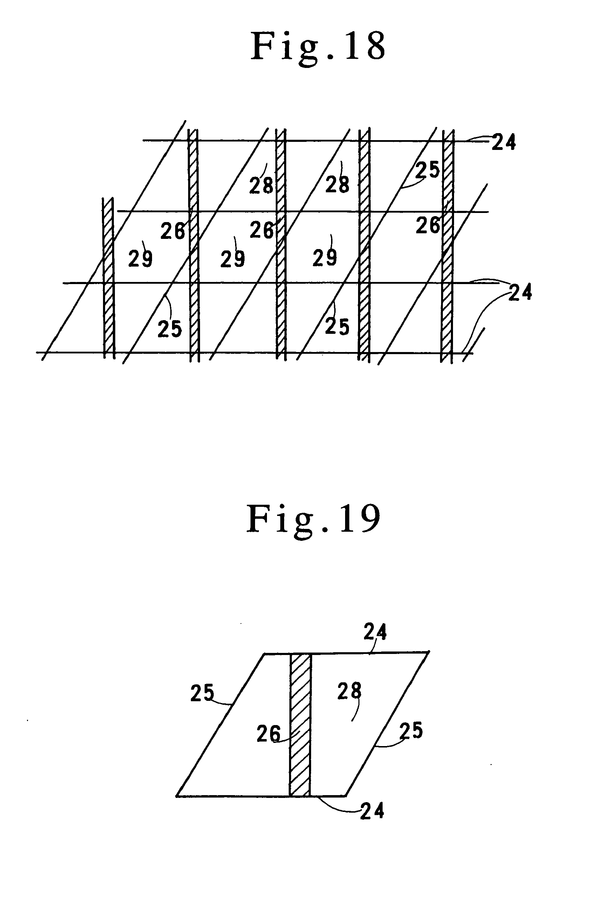

Fig. 18 is a partial plan view of the wafer in which quadrilateral LDs assigning cleavage planes to resonators are produced by cutting off along a group of cleavage planes making an angle of 120 degrees to each other in the LD having a strip structure.
Fig.19 is a plan view of an LD chip in which the cleavage planes produced by cutting off along a group of cleavage planes making an angle of 120 degrees to each other are assigned to resonator surfaces.

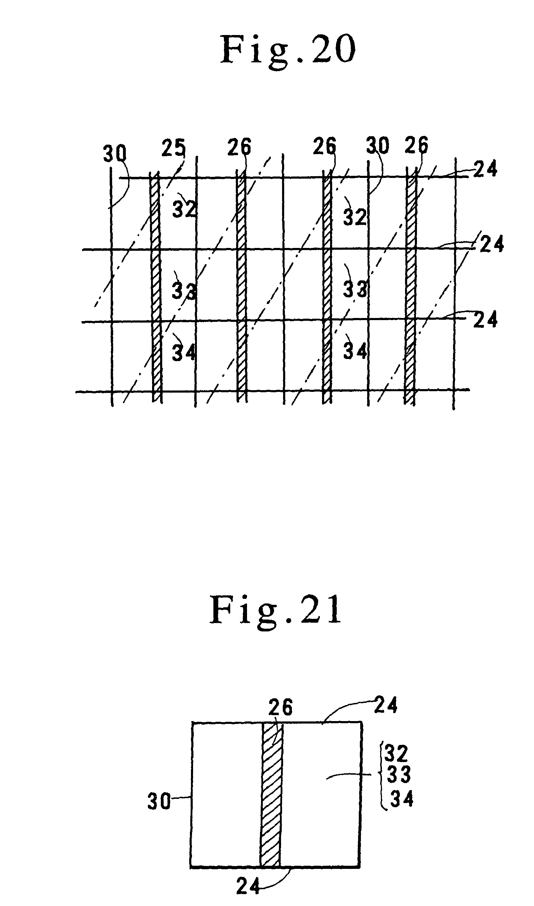

Fig.20 is a partial plan view of the wafer in which the LD chips are made by cutting off by lines 24 along the cleavage planes in the directions intersecting at right angles to the strips and cutting off by lines 30 along non-cleavage planes in the directions in parallel to the strips.
Fig.21 is a plan view of the LD chip which is made by cutting along the cleavage planes perpendicular to the stripes and cutting along the non-cleavage planes in parallel with the stripes.

### [Embodiment 1: producing of GaN substrate]

The method of producing a GaN substrate will be explained by referring to Fig.4(1) to Fig.4(4). A GaAs (111) A surface wafer having a diameter of 2 inches is used as a substrate. After an insulated layer made from SiO₂ has been formed on the GaAs substrate as a mask, a group of dotted windows is bored on the mask by photolithography. This condition is shown in Fig.1 and Fig.4(1). All dotted windows are shaped in 2 µm squares. A series of dotted windows are lined up at intervals of 4 µm pitch in [11-2] direction. Another series of dotted windows are lined up at a distance of 3.5 µm pitch away from the first line. The second series are lined at the same intervals (4 µm pitch) in [-110] direction. The same line arrangement is repeated till all the dotted windows have been lined up fully on the mask. Here, neighboring lines are arranged to deviate from each other in phase of 1/2 pitch in line [11-2] direction.

Further, buffer layers having a thickness of about 80 nm are formed on the GaAs substrate exposed in the windows at a temperature of about 490 °C by HVPE (Halide VPE) method. This state is shown by Fig.4(2). A GaN epitaxial layer having a thickness of about 120 µm is grown further on the buffer layer at a temperature of about 970°C by heating the GaAs substrate. The sample attains to the state shown by Fig. 4(3) of a GaN/GaAs structure, passing the states shown by Fig.2 and Fig.3.

Then, the GaAs substrate is removed from the GaN/GaAs wafer by aqua regia, which is shown by Fig.4(4). We obtained an independent freestanding single GaN substrate with a thickness of about 120 µm enough to become a freestanding layer.

This GaN substrate is a single crystal and displays n-type conductivity. The surface of the GaN substrate is a (0001) plane. Hence, the normal line is in parallel with c axis. The cleavage of GaN was confirmed to be actually cut on the cleavage plane {1-100} of GaN. Particularly, it was found that the scribed lines formed on the rear surface of the GaN helps to implement an extremely easy cleavage of GaN. We confirmed that the cleavage planes are straight lines, and the cleavage cut planes are even. The GaN chip having sides of {1-100} cleavage plane can be produced by making use of the {1-100} cleavage plane. In particular, this invention produces LEDs and LDs having side surfaces of {1-100} cleavage planes.

### [Embodiment 2]

A GaN single crystal substrate (0001), which has been produced by the same method as Embodiment 1, is a start material. However, Embodiment 2 differs from Embodiment 1 in the shapes of mask and window. In Embodiment 2, pairs of a striped window having a width of 2 µm and a striped mask having a width of 3 µm are repeatedly lined up in [1-100] direction. An independent freestanding GaN substrate approximately equivalent to Embodiment 1 can be obtained. An LED epitaxial structure is formed on the GaN (0001) surface by MOCVD method. This structure is as same as the LEDs put on sale. Fig.6 is a sectional view of the structure. An n-AlGaN layer 13, a Zn-doped n-InGaN 14, a p-AlGaN 16 and a p-GaN 17 are epitaxially grown in the order on the GaN substrate 12. The substrate and all epitaxially grown layers are GaN-type crystals. No foreign material is contained. Further, a conductive transparent electrode 20 is positioned on the p-GaN layer, and a p-side electrode 21 is positioned on the conductive transparent electrode 20. An n-side electrode 22 is formed on the rear surface of the GaN substrate.

Fig.7 from Fig.11 show various shapes of LED chips. Fig.12 from Fig.16 show various groups of cleavage lines. Since the n-GaN substrate has a GaN(0001) orientation, the {1-100} plane on the GaN(0001) is perpendicular to the surface of the substrate but each cleavage plane is at an angle of 60 degrees with each other. No right angle is obtained. Therefore, if only natural cleavage tries to form all the outlines of chips, each vertex of chips is restricted to have an inner angle of 120 degrees or 60 degrees.

Fig.7 shows an equilateral triangle-type LED that has three cleavage planes, i.e. (1-100), (01-10) and (-1010) on the side surfaces. Such a triangle-type LED is unfamiliar but there are no problems to use as a semiconductor chip capable of using independently. It is very simple to draw cutting lines in parallel with each other in three direction on the rear surface of the GaN wafer. Fig.12 shows a group of cutting lines along the cleavage planes.

Fig.8 shows a lozenge(rhombic)-type LED chip that has four cleavage planes, (0-110), (10-10), (01-10) and (-1010) on the side surfaces. When cut lines are drawn on the rear surface of a wafer, a pair of two parallel cutting lines are repeatedly formed at regular intervals. Fig.13 shows a group of cutting lines. A lozenge-type semiconductor chip is rare but there is no inconvenience in the handling.

Fig.9 shows a quadrilateral(parallelogrammic)-type LED chip having four cleavage planes, i.e. (0-110), (10-10), (01-10) and (-1010) in the side surfaces. The cleavage planes are the same as the lozenge-type LED chip, but the quadrilateral-type LED chip has neighboring sides of different lengths. When cutting lines are drawn on the rear surface of the wafer, a pair of two cutting lines in parallel with each other at an angle of 60 degrees are repeatedly drawn, as shown by Fig. 14. Here, the intervals between two pairs of two parallel cutting lines are different. Such a quadrilateral-type LED chip is preferable for LEDs that are required to have anisotropy.

Fig. 10 shows a trapezoid-type LED chip having four cleavage planes, i.e. (1-100), (10-10), (01-10) and (-1010) on the side surfaces. The trapezoid can be shaped by combining three triangles or five triangles. It is unprecedented that the shape of trapezoid is adopted as a semiconductor chip. First cleavage is practiced in long-side direction, and second cleavage is practiced in the direction making an angle of 60 degrees to the long side direction, which is shown by Fig.15. The cleavage at a stroke is impossible. The shape of trapezoid having no translation symmetry is difficult to be cut at once. This type is rather preferable as an anisotropic light source.

Fig.11 shows a hexagon-type LEC chip having six cleavage planes, i.e. (1-100), (10-10), (01-10), (-1100), (-1010) and (0-110) on the side surfaces. The shape of hexagon is strange for semiconductor chips. The cutting along the cleavage planes is possible but not easy. Fig.16 shows a group of cutting lines. Some idea should be necessary for cutting the lines shaped like honeycombs, for example, to use a cut tool shaped like a honeycomb.

The GaN single crystal substrate with the epitaxial growing layers is diced up into a plurality of chips along the {1-100} cleavage plane. Simple and clear dicing is implemented due to the natural cleavage.

When a current was supplied to these devices from the p-side electrode to the n-side electrode, bright blue light emission is recognized. The devices are confirmed to act normally as LEDs.

The dicing of chips making use of the natural cleavage is simple and accurate. In this case, the yield is raised in comparison with the scribing carried out for dividing GaN devices on the sapphire substrate. High yield enables blue light emitting devices to reduce the production cost.

GaN cleavage plane is {1-100}. {1-100} cleavage has an advantage of being perpendicular to (0001) surface but has a disadvantage of not making right angles to each other. It will be better and convenient for LED chips to have the sides perpendicular to each other. Making the cleavage planes vertical is not impossible, which is explained by Fig. 17. The regular hexagon efghij is a cleavage plane on the (0001) surface. Each side is at an angle of 60 degrees with each neighboring side. Since the cleavage planes are vertical to the (0001) surface, the side surfaces of the regular hexagon perpendicular to the (0001) surface are said to be cleavage planes. When the regular hexagon cylinder is cut at an inclining angle of 45 degrees, an irregular hexagon as shown in the bottom right of Fig. 17 is obtained. The side ij meets at right angles with the side ej, and the side gh meets at right angles with the side gf. The cleavage planes being at right angles with each other are revealed. Then, the LED chip shaped like a rectangle is made by adopting only the cleavage planes of gh, gf, ji, and ej as cutting lines. It is a little strange that the cleavage planes are not at right angles with the surface but are at 60 degrees with the surface. The slantingly cut surface is a (1001) plane which has the difficulty of growing. Therefore, current techniques can not overcome this difficulty. If the GaN layer were epitaxially grown originally on the GaAs(111) surface, a long-size GaN crystal much longer than a diameter of the wafer should be grown. Such a technique is not be established at present.

### [Embodiment 3: in the case of LD]

The GaN laser devices grown on the GaN(0001) substrate produced by Embodiment 1 are diced up into chips. The striped structure of active layers is made by forming an AlGaN layer, an InGaN MQW layer, an AIGaN layer and a p-type GaN layer on the GaN substrate in order by MOCVD method, and by forming patterns like stripes.

The striped structure is arranged to be vertical to a cleavage mirror surface in the longitudinal direction. As mentioned above, since the cleavage plane is {1-100}, the direction of the strip ought to be 〈1-100〉. The laser structure is made, as shown in Fig. 18, and strips 26 are formed in parallel with each other in 〈1-100〉 . The scribing is done by cutting lines 24, 24, .... which are vertical to the stripes and cutting lines 25, 25, .... which are at an angle of 120 degrees with the cutting lines 25. The side surfaces 24 and 25 are all cleavage planes, so that the chips are separated by giving an impact to the striped structure after the rear surface of the wafer has been scribed. The LD chip is shaped like a quadrilateral, as shown by Fig.9. The end surfaces 24, 24 are cleavage planes which are both end surfaces of the strip. The end surfaces enjoying cleavage contain not only the substrate surface but also the epitaxial layer surfaces. This cleavage plane becomes a resonator mirror which is superior to the resonator of sapphire substrate GaN lasers in the properties of evenness, smoothness, high reflection factor and high yield.

The four sides of the quadrilateral LD are cleavage planes. This is faithful to the assertion of this invention, but a half of the wafer area becomes in vain even if it goes well as long as the stripe structure is required. As known from Fig. 18, even if the position of strips is determined anywhere, lines intersecting the slanting cutting lines 25 with the stripes 26 are generated in chips 29. Such chips 29, 29 can not be used.

To solve the problem, as shown in Fig.20, the cutting lines 24, 24 intersecting at right angles to the stripes 26 are along the cleavage planes but the cutting lines 30, 30 are not along the cleavage planes. Hence, slanting cleavage planes 25 are not used. Such a chip is shown by Fig.21. There are no useless chips. Even if it takes time to cut non-cleavage plane cutting lines 30,30 and the cut surfaces are suffering from a little roughness, there occurs no problem in the non-mirror surfaces.

## Claims

1. A method of producing a gallium nitride-type light emitting semiconductor device comprising the steps of:
growing GaN-type semiconductor epitaxial layers on a (0001) top surface gallium nitride single crystal substrate;
forming an electrode on the GaN-type semiconductor epitaxial layers;
forming an electrode on a bottom surface of the gallium nitride single crystal substrate;
forming scribing lines on the bottom surface of the gallium nitride single crystal substrate along {1-100} planes of the gallium nitride single crystal substrate;
cutting the gallium nitride single crystal substrate into chips by cleaving along the scribed lines; and
obtaining light emitting device chips having sides consisting of {1-100} planes made by natural cleavage.

2. The method as claimed in claim 1, wherein parallel scribing lines are drawn in 60 degree different three directions on the bottom surface of the gallium nitride single crystal substrate and the light emitting device chips are triangle LED chips having sides consisting of cleavage planes.

3. The method as claimed in claim 1, wherein parallel scribing lines are drawn in 60 degree different two directions on the bottom surface of the gallium nitride single crystal substrate and the light emitting device chips are parallelogram LED chips having sides consisting of cleavage planes.

4. The method as claimed in claim 1, wherein parallel scribing lines are drawn in one direction, the gallium nitride single crystal substrate is cut in the scribing lines by natural cleavage, drawing scribing lines inclining 60 degrees to the cut lines on the cut substrates, the cut substrates are cut into chips and the light emitting device chips are trapezoid LED chips having sides consisting of cleavage planes.

5. The method as claimed in claim 1, wherein parallel scribing lines are drawn in 60 degree different two directions on the bottom surface of the gallium nitride single crystal substrate and the light emitting device chips are parallelogram LD chips having sides consisting of cleavage planes and having cleavage sides as resonator mirrors.

6. The method as claimed in claim 1, wherein parallel scribing lines are drawn in one direction, the gallium nitride single crystal substrate is cut in the scribing lines by natural cleavage, drawing scribing lines inclining 60 degrees to the cut lines on the cut substrates, the cut substrates are cut into chips and the light emitting device chips are trapezoid LD chips having sides consisting of cleavage planes and having cleavage sides as resonator mirrors.
